# DEMANDE DE BREVET EUROPEEN

(11) **EP 2 495 754 A2**
(43) Date de publication de la demande: **05.09.2012**
(21) Numéro de dépôt: 12155129.5
(22) Date de dépôt: 13.02.2012
(51) Int. Cl.: H01L 21/033, H01L 21/3213

(54) **Procede de fabrication d'un circuit integre base sur la formation de lignes et de tranchees**

(30) Priorité: 04.03.2011 FR 1100662
(71) Demandeur: STMicroelectronics (Crolles 2) SAS, 38920 Crolles (FR)
(72) Inventeur: Gouraud, Pascal, 38330 Montbonnot St Martin (FR); Le-Gratiet, Bertrand, 38100 GRENOBLE (FR)
(74) Mandataire: de Roquemaurel, Bruno

(57) **Abrégé**

L'invention concerne un procédé de gravure d'une couche cible, comprenant des étapes consistant à : déposer une couche de masque dur (HM) sur une couche cible (TL) et sur la couche de masque dur, une première couche photosensible, exposer la première couche photosensible au travers d'un premier masque pour transférer des premiers motifs dans la couche photosensible, transférer les premiers motifs dans la couche de masque dur, déposer sur la couche de masque dur gravée une seconde couche photosensible (PR'), exposer la seconde couche photosensible au travers d'un second masque pour transférer des seconds motifs dans la seconde couche photosensible, transférer les seconds motifs dans la couche de masque dur par gravure de cette couche, et transférer les premiers et seconds motifs dans la couche cible au travers du masque dur, les seconds motifs formant des lignes (L1, L2, L3), et les premiers motifs (R1, R2) formant des tranchées coupant les lignes dans le masque dur.

## Description

La présente invention concerne un procédé de fabrication de composants électroniques sur un substrat semi-conducteur. Elle concerne en particulier les procédés de photolithographie mettant en oeuvre des étapes successives de gravure de motifs dans une couche dite de "masque dur" ("hard mask") déposée sur une couche cible.

Les procédés de photolithographie consistent à graver des motifs à l'aide d'une couche en un matériau photosensible, tel qu'une résine photosensible ("photoresist") déposée sur une couche cible à traiter formée sur un substrat. Une couche appelée "masque dur" ("hard mask") peut être déposée sur la couche cible avant de déposer la couche de résine photosensible. Le motif à transférer à la couche cible est alors transféré à la couche de résine par photolithographie, puis par gravure à la couche de masque dur et à la couche cible. Un transfert de motifs à la couche de résine photosensible consiste généralement à exposer la couche dans une machine de photolithographie à un faisceau de particules au travers d'un masque présentant les motifs à transférer, puis à retirer les parties exposées (dans le cas d'une résine positive) ou non exposées (dans le cas d'une résine négative) à l'aide d'un solvant de développement. La taille minimum des motifs susceptibles d'être transférés à une couche photosensible est appelée "dimension critique" (CD) et correspond par exemple à la largeur d'une ligne de motif. La dimension critique dépend de caractéristiques de la machine d'exposition de photolithographie et notamment du dispositif de projection optique, et des caractéristiques de l'exposition, du développement et du matériau photosensible utilisé.

Pour réduire davantage la dimension critique de motifs susceptibles d'être gravés dans une couche cible sans changer de machine de photolithographie, on a développé plusieurs procédés de transferts multiples de motifs ("multiple patterning"). Certains de ces procédés consistent à transférer successivement plusieurs motifs à une couche de masque dur formée sur la couche cible, en redéposant une nouvelle couche de résine sur la couche de masque dur entre chaque transfert. Selon un procédé de transfert multiple décrit dans le brevet US 6 787 469, des motifs de ligne d'un premier masque utilisé, présentent des lignes parallèles ayant la dimension critique du traitement de photolithographie. Des motifs de coupe d'un second masque utilisé, présentent des formes visant à retirer une partie des motifs de ligne, et notamment à couper certaines lignes formées par les motifs de ligne. Ce procédé est utilisé notamment pour former des grilles de transistors CMOS en polysilicium, pouvant atteindre à l'heure actuelle, une largeur minimum de l'ordre de 30 nm.

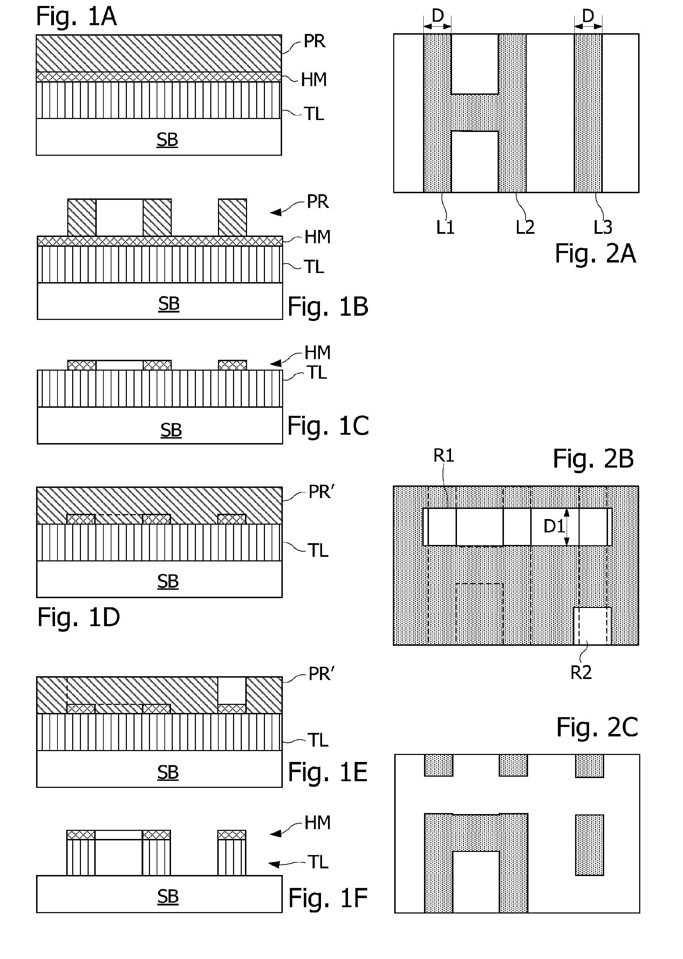

Un tel procédé de photolithographie à transferts multiples de motifs est illustré par les figures 1A à 1F et 2A à 2C. Les figures 1A à 1F représentent en coupe transversale une partie d'une structure multicouche formée à partir d'une plaquette en un matériau semi-conducteur ("wafer"), à différentes étapes d'un procédé de photolithographie. Les figures 2A à 2C représentent en vue de dessus une partie de la structure multicouche à certaines des étapes du procédé de photolithographie. Sur la figure 1A, la structure multicouche comprend un substrat SB sur laquelle est formée une couche cible TL. La couche cible TL est recouverte d'une couche de masque dur HM, et la couche HM est recouverte d'une couche de résine photosensible PR. Sur la figure 1B, des motifs de ligne formés sur un premier masque ont été transférés à la couche PR par une machine de photolithographie. La figure 2A présente la forme des motifs de ligne transférés à la couche PR. Sur la figure 2A, les motifs de ligne forment des lignes parallèles L1, L2, L3, parmi lesquelles deux lignes adjacentes L1, L2 sont reliées par un pont. Les lignes L1, L2, L3 formées dans la couche traitée présentent une largeur D pouvant correspondre à la dimension critique du traitement de photolithographie. Cette largeur est déterminante sur les performances électriques de composants qui seront formés par les motifs de ligne dans la couche cible TL.

Sur la figure 1C, les motifs de ligne ont été transférés à la couche HM par un traitement de gravure et la couche PR a été retirée. Sur la figure 1D, la couche HM est à nouveau recouverte d'une couche de résine photosensible PR'. Sur la figure 1E, des motifs de coupe formés sur un second masque ont été transférés à la couche PR' par la machine de photolithographie. La figure 2B présente la forme des motifs de coupe transférés à la couche PR'. Sur la figure 2B, les motifs de coupe forment des tranchées rectangulaires R1, R2 prévues pour couper les lignes L1, L2, L3 qui ont été formées dans la couche HM. Les tranchées R1, R2 présentent une largeur D1 qui peut être supérieure à la dimension critique CD. Contrairement aux motifs de ligne, les motifs de coupe présentent des dimensions qui ne sont pas déterminantes sur les performances électriques des composants formés par les motifs de ligne. Il importe simplement que les motifs de coupe coupent les lignes en des emplacements souhaités pour former des composants électroniques distincts.

Sur la figure 1F, la couche HM a été gravée à la forme des motifs transférés dans la couche PR', la couche PR' a été retirée, et la couche cible TL a été gravée à la forme des motifs transférés dans la couche HM. La figure 2C présente la forme des motifs ainsi formés dans les couches HM et TL. Ces motifs correspondent aux lignes L1, L2, L3 auxquelles ont été retirées les zones rectangulaires R1, R2. La couche de masque dur HM peut ensuite être totalement retirée.

En pratique, tous les traitements entre la gravure des lignes et la gravure finale de la couche de masque dur ont un effet réducteur de la dimension critique des motifs formés dans cette couche et donc dans la couche cible. Chaque traitement de gravure est donc suivi d'une étape de métrologie durant laquelle sont mesurés différents paramètres incluant la dimension critique. Le traitement de photolithographie formant les motifs de ligne dans la couche PR peut être adapté si la dimension critique mesurée dévie de celle à atteindre. De même, les mesures obtenues à la suite la première gravure de la couche de masque dur HM (figure 1C) sont prises en compte lors du second traitement de gravure pour effectuer d'éventuelles corrections. Des mesures finales permettent de déterminer si les motifs ont été correctement transférés à la couche cible TL.

Toutes les étapes de traitement affectent la dimension critique sauf l'étape de photolithographie de la couche PR'. Cette étape pourrait donc être effectuée avec une machine de photolithographie moins précise et donc moins coûteuse que celle devant être utilisée pour les autres étapes de photolithographie. Cependant, un changement de machine de photolithographie durant un procédé de "multiple patterning" à la dimension critique soulève plusieurs problèmes délicats et notamment des problèmes d'alignement des deux motifs de masque à transférer sur la plaquette de semi-conducteur. Lors du traitement des structures à dimension critique, les mesures obtenues lors du premier traitement de gravure du masque dur doivent pouvoir être utilisées pour ajuster le second traitement de gravure du masque dur. Si un changement de machine est intervenu entre ces deux traitements de gravure du masque dur, ces mesures doivent être sauvegardées et introduites dans la machine assurant le second traitement de gravure du masque dur.

Il est donc souhaitable de simplifier un tel procédé de "multiple patterning". Il est également souhaitable de réduire le temps d'utilisation d'une machine de photolithographie coûteuse, notamment en permettant l'utilisation d'une machine de photolithographie moins coûteuse pour les traitements n'intervenant pas à la dimension critique.

Des modes de réalisation concernent un procédé de gravure d'une couche cible, comprenant des étapes consistant à : déposer une couche de masque dur sur une couche cible et sur la couche de masque dur, une première couche en un matériau photosensible, exposer la première couche photosensible à un faisceau de particules au travers d'un premier masque pour transférer des premiers motifs, former les premiers motifs dans la couche photosensible, transférer les premiers motifs dans la couche de masque dur par gravure de cette couche au travers de la première couche photosensible, déposer sur la couche de masque dur gravée une seconde couche en un matériau photosensible, exposer la seconde couche photosensible à un faisceau de particules au travers d'un second masque pour transférer des seconds motifs, former les seconds motifs dans la seconde couche photosensible, transférer les seconds motifs dans la couche de masque dur par gravure de cette couche au travers de la seconde couche photosensible, et transférer les premiers et seconds motifs dans la couche cible par gravure de cette couche au travers de la couche de masque dur, les seconds motifs formant des lignes dans la couche de masque dur, et les premiers motifs formant des tranchées coupant les lignes dans la couche de masque dur.

Selon un mode de réalisation, entre les étapes de seconde gravure de la couche de masque dur et de gravure de la couche cible, le procédé comprend des étapes consistant à : déposer sur la couche de masque dur gravée une troisième couche en un matériau photosensible, exposer la troisième couche photosensible à un faisceau de particules au travers d'un troisième masque pour transférer des troisièmes motifs, former les troisièmes motifs dans la troisième couche photosensible, et transférer les troisièmes motifs dans la couche de masque dur par gravure de cette couche au travers de la troisième couche photosensible, la couche cible étant gravée en recevant les premiers, seconds et troisièmes motifs formés dans la couche de masque dur, les troisièmes motifs formant des lignes coupées par les premiers motifs.

Selon un mode de réalisation, l'une ou chacune des couches photosensibles est déposée directement sur la couche de masque dur, préalablement gravée ou non, la couche photosensible présentant un coefficient de réflexion du faisceau de particules inférieur à 1%, et une face supérieure plane, et couvre la couche de masque dur sans emprisonner de bulles de gaz.

Selon un mode de réalisation, une couche supplémentaire est déposée directement sur la couche de masque dur, préalablement gravée ou non, l'une ou chacune des couches photosensibles étant déposée sur la couche supplémentaire, le procédé comprenant une étape de gravure de la couche supplémentaire pour transférer les motifs formés dans la couche photosensible à la couche supplémentaire.

Selon un mode de réalisation, la couche supplémentaire présente un coefficient de réflexion du faisceau de particules inférieur à 1%, et une face supérieure plane, et couvre la couche de masque dur sans emprisonner de bulles de gaz.

Selon un mode de réalisation, la surface supérieure de l'une ou de chacune des couches photosensibles présente une variation de hauteur inférieure à 20%, et de préférence, inférieure à 15%.

Selon un mode de réalisation, l'une ou chacune des couches photosensibles est déposée sur une seconde couche de masque dur, la seconde couche de masque dur étant déposée sur la couche supplémentaire, le procédé comprenant une étape de gravure de la seconde couche de masque dur pour transférer les motifs formés dans la couche photosensible à la couche de masque dur.

Selon un mode de réalisation, la couche cible est une couche prévue pour former des grilles de transistors CMOS.

Des exemples de réalisation de l'invention seront décrits dans ce qui suit, à titre non limitatif en relation avec les figures jointes parmi lesquelles :
les figures 1A à 1F décrites précédemment représentent en coupe transversale une partir d'une structure multicouche formée à partir d'une plaquette en un matériau semi-conducteur, à différentes étapes d'un procédé de photolithographie,
les figures 2A à 2C décrites précédemment représentent en vue de dessus la partie de structure multicouche à certaines des étapes du procédé de photolithographie,
la figure 3 représente une séquence d'étapes d'un procédé de photolithographie, selon un mode de réalisation,
les figures 4A à 4F représentent en coupe transversale une partie de structure multicouche formée à partir d'une plaquette en un matériau semi-conducteur, à différentes étapes du procédé de photolithographie,
les figures 5A à 5C représentent en vue de dessus la partie de structure multicouche à certaines des étapes du procédé de photolithographie,
la figure 6 représente une partie de structure multicouche formée dans un procédé de photolithographie, selon un autre mode de réalisation,
les figures 7A à 7E représentent en coupe transversale une partie de structure multicouche, à différentes étapes d'un procédé de photolithographie, selon un autre mode de réalisation,
les figures 8A à 8D représentent en vue de dessus la structure multicouche à certaines des étapes du procédé de photolithographie.

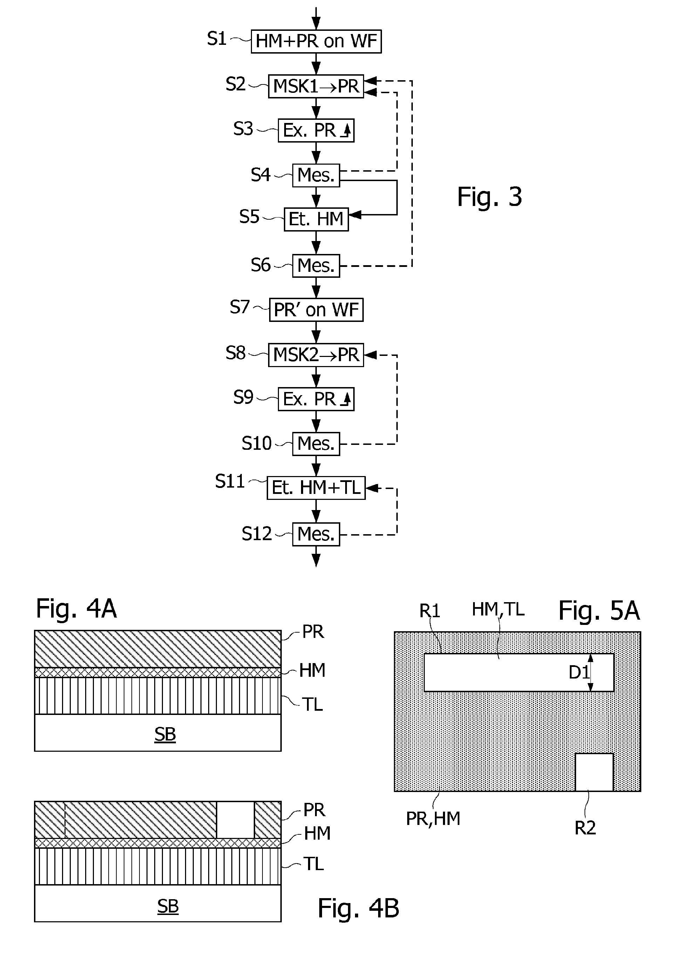

La figure 3 représente une séquence d'étapes d'un traitement de photolithographie d'une couche cible dans une structure multicouche formée sur un substrat par exemple en un matériau semi-conducteur. La séquence d'étapes comprend des étapes S1 à S12. La couche cible est la couche dans laquelle des motifs doivent être transférés par exemple pour réaliser des composants électroniques de circuit intégré.

A l'étape S1, une couche de masque dur HM et une couche en un matériau photosensible PR sont déposées successivement sur une couche cible TL. La figure 4A représente une structure multicouche qui peut être obtenue à l'issue de l'étape S1. Sur la figure 4A, la structure multicouche comprend la couche cible TL à traiter par le procédé de photolithographie, la couche cible étant formée sur un substrat SB. La couche TL est recouverte par la couche HM, et la couche HM est recouverte de la couche PR.

A l'étape S2, la couche PR est soumise à un faisceau de particules (photons, électrons, ...) au travers d'un masque MSK1. L'étape S3 est une étape de développement durant laquelle sont retirées les parties exposées (ou non exposées) par la machine de photolithographie au travers du masque MSK1. La figure 4B représente la structure multicouche après le transfert des motifs du masque MSK1 à la couche PR. La figure 5A représente la forme des motifs transférés à la couche PR. Selon un mode de réalisation, les motifs transférés par le masque MSK1 à la couche PR sont des motifs de coupe permettant de former des tranchées dans la couche de masque dur HM. Les motifs de coupe présentent une dimension minimum qui peut être supérieure à la dimension critique du traitement de photolithographie. Dans l'exemple illustré par la figure 5A, les motifs du masque MSK1 transférés dans la couche PR comprennent deux tranchées R1, R2 de forme rectangulaire dont la largeur D1 peut être supérieure à la dimension critique de la machine de photolithographie employée.

L'étape S4 qui suit est une étape de métrologie permettant de contrôler la qualité du transfert du masque MSK1 à la couche PR. Si, sur un lot de plaquettes, les motifs R1, R2 présentent des dimensions supérieures ou inférieures à des dimensions souhaitées, le traitement de photolithographie réalisé aux étapes S2, S3 peut être réajusté pour un lot de plaquettes suivant. Ce réajustement en fonction de mesure forme une boucle de régulation (ici de type rétroaction également appelé "Run to Run") qui permet d'améliorer la qualité globale des lots de plaquettes ainsi produits. Les mesures obtenues à l'étape S4 sur un lot de plaquettes donné, peuvent également être utilisées pour ajuster sur ce même lot de plaquettes, les paramètres gravure de la couche de masque dur à l'étape de S5 suivante. Ce réajustement effectué à une étape suivante (couramment appelé "Feed Forward"), basé sur des mesures obtenues à une étape précédente, est également d'importance pour la maîtrise des procédés de fabrication.

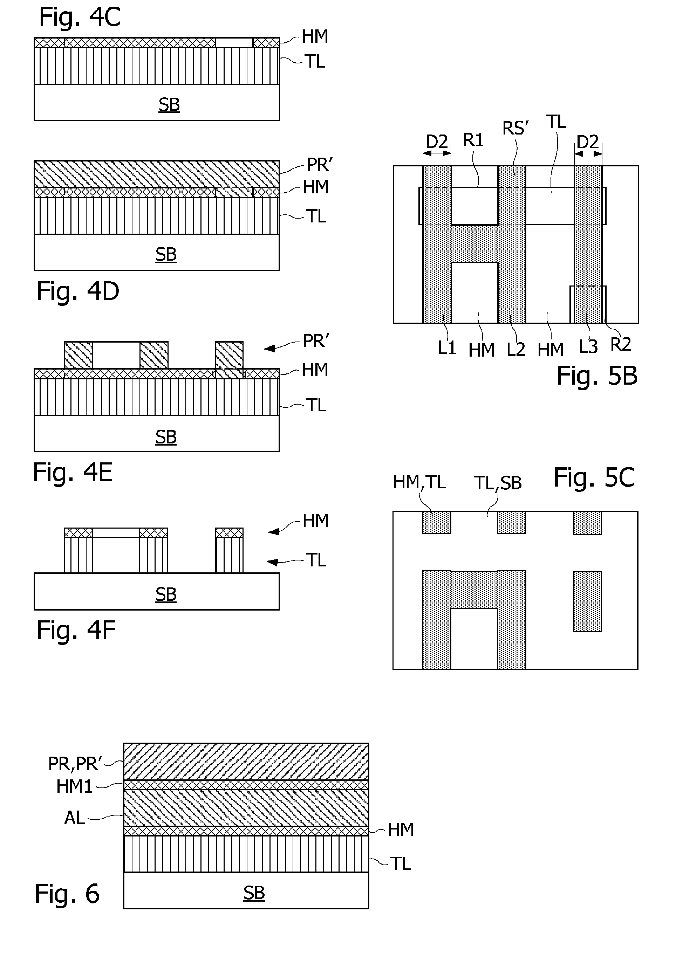

La forme et les dimensions des motifs R1, R2 ainsi transférés ne sont pas déterminantes sur la qualité du résultat final du traitement de la couche cible TL. A l'étape S5, la couche HM est gravée au travers de la couche PR, afin de transférer les motifs formés dans la couche PR à la couche HM, et la couche PR est retirée. La figure 4C représente la structure multicouche à l'issue de l'étape S5. L'étape S6 qui suit est une étape de métrologie visant à contrôler les dimensions des motifs transférés à la couche de masque dur HM. Si les mesures obtenues à l'étape S6 ne sont pas satisfaisantes, le traitement de photolithographie réalisé aux étapes S2, S3 peut être réajusté pour un lot de plaquettes suivant.

A l'étape S7, une nouvelle couche de résine photosensible PR' est déposée sur la couche HM qui a été gravée à l'étape S5. La figure 4D représente la structure multicouche à l'issue de l'étape S7. Cette étape est par exemple réalisée par centrifugation, en déposant de la résine liquide au centre d'une plaquette en un matériau semi-conducteur formant le substrat SB, et en faisant tourner la plaquette. A l'étape S8, la couche de résine PR' est soumise à un faisceau de particules (photons, électrons, ...) au travers d'un masque MSK2.

L'étape S9 est une étape de développement durant laquelle sont retirées les parties exposées (ou non exposées) par la machine de photolithographie au travers du masque MSK2. La figure 4E représente la structure multicouche après le transfert des motifs du masque MSK2 à la couche PR'. Selon un mode de réalisation, les motifs transférés par le masque MSK2 à la couche PR' sont des motifs de ligne présentant une dimension minimum qui peut être égale à la dimension critique du traitement de photolithographie. La figure 5B représente la forme des motifs transférés à la couche PR'. Sur la figure 5B, les motifs transférés présentent des lignes L1, L2, L3, parmi lesquelles les lignes adjacentes L1, L2 sont reliées par un pont. Les lignes L1, L2, L3 formées dans la couche PR' présentent une largeur D2 qui peut être égale à la dimension critique du traitement de photolithographie. Cette largeur est déterminante sur les performances électriques de composants qui seront formés par les motifs de ligne dans la couche cible TL. Au contraire, les motifs de coupe R1, R2 présentent des dimensions qui ne sont pas déterminantes sur les performances électriques des composants formés par les motifs de ligne. Il importe simplement que les motifs de coupe coupent les lignes en des emplacements souhaités pour former des composants électroniques distincts.

L'étape S10 qui suit est une étape de métrologie visant à contrôler les dimensions des motifs transférés à la couche PR'. Si à l'étape S10, les dimensions des motifs transférés dans la couche PR' étaient supérieures ou inférieures à des dimensions souhaitées, le traitement de photolithographie réalisé aux étapes S8, S9 peut être réajusté pour un lot de plaquettes suivant. A l'étape S11, la couche HM est gravée à la forme des motifs transférés dans la couche PR', et la couche PR' est retirée. Si à l'étape S10, les dimensions des motifs transférés dans la couche PR' étaient supérieures à des dimensions souhaitées, le traitement de gravure de la couche HM peut être prolongé. La couche cible TL est ensuite gravée à la forme des motifs R1, R2, L1, L2, L3 transférés à la couche HM. La figure 4F représente la structure multicouche à l'issue du traitement de gravure à l'étape S11. La figure 5C présente la forme des motifs formés dans les couches HM et TL. Ces motifs correspondent aux lignes L1, L2, L3 auxquelles ont été retirées les zones rectangulaires R1, R2. La couche de masque dur HM peut ensuite être totalement retirée. L'étape S12 qui suit est une étape de métrologie visant à déterminer notamment si les dimensions des motifs transférés dans la couche cible TL correspondent à celles souhaitées. Si les mesures obtenues à l'étape S12 ne sont pas satisfaisantes, les traitements de photolithographie réalisés aux étapes S2, S3 et S8, S9 peuvent être réajustés pour un lot de plaquettes suivant.

Les traitements de gravure de la couche de masque dur ont un effet réducteur de la dimension critique des motifs formés dans cette couche et donc dans la couche cible. Ainsi, dans un exemple de réalisation, les motifs L1, L2, L3 transférés dans la couche PR' présentent une dimension critique de 52 nm, et lorsqu'ils sont transférés dans la couche cible TL, ils peuvent atteindre une dimension de 34 nm. Les étapes de métrologie sont par exemple effectuées à l'aide d'un microscope électronique à balayage SEM (Scanning Electron Microscope), ou par scattérométrie. Les motifs ainsi formés dans la couche cible TL permettent de réaliser par exemple des grilles de transistors CMOS, la couche TL étant alors en polysilicium monocristallin. La largeur D2 des lignes L1, L2, L3 correspond à la longueur des grilles des transistors ainsi formés. Ces lignes présentent donc une dimension (leur largeur) qui est déterminante sur les performances électriques de ces transistors. Au contraire, aucune des dimensions des motifs R1, R2 n'est déterminante sur les performances électriques de ces transistors. Seule la présence des tranchées R1, R2 est nécessaire pour séparer les grilles de transistors formées collectivement par les lignes L1, L2, L3.

On observe que la formation de motifs L1, L2, L3 dans la couche de masque dur HM n'est pas altérée par la présence des tranchées R1, R2 formées au préalable dans la couche HM. En effet, pour qu'une couche photosensible soit correctement exposée, il est nécessaire que la surface à exposer soit très plane. Le dépôt d'une couche photosensible sur le moindre relief est donc à éviter en particulier lorsque les structures à former sont très critiques en ce qui concerne leurs dimensions. Dans le cas présent, le dépôt de la couche photosensible PR' sur les tranchées R1, R2 formées dans la couche HM était donc à éviter. Il s'avère que le dépôt sur la couche de masque dur HM d'une couche présentant des propriétés planarisante et anti-réflective peut être suffisant pour s'affranchir de la présence de relief (tranchées R1, R2) dans la couche HM. Ainsi, la résine employée pour former la couche PR' peut être choisie afin de couvrir la couche HM en pénétrant dans les tranchées R1, R2 formées à l'étape S5 sans emprisonner de bulles de gaz, et présenter une face supérieure suffisamment plane et anti-réflective, à l'issue de son dépôt sur la couche HM pour ne pas affecter les traitements suivants de photolithographie et de gravure de la couche de masque dur HM. En pratique, il est souhaitable que la couche déposée sur la couche de masque dur HM possède des propriétés planarisantes suffisantes pour que sa surface supérieure présente, notamment de part et d'autre du bord d'un motif de tranchée R1, R2, une variation de sa hauteur inférieure à 20%, et de préférence, inférieure à 15%, cette variation étant exprimée en pourcentage de la profondeur de champ du traitement de photolithographie employé. Par exemple, pour un traitement de photolithographie présentant une profondeur de champ de 120 nm et un masque dur de 30 nm d'épaisseur, les variations locales de hauteur induites par la présence des tranchées représenteraient 25% de la profondeur de champ. En l'absence de couche présentant des propriétés planarisantes suffisantes, la surface supérieure de la résine PR' présenterait elle aussi des variations locales représentant 25% de la profondeur de champ, ce qui est inacceptable en pratique pour une étape de photolithographie critique. En revanche, une couche de résine permettant de réduire à moins de 20 nm à sa surface supérieure, les variations de hauteur de 30 nm induites à sa surface inférieure par les tranchées, permet de réduire les variations locales de hauteur de la surface supérieure de la résine à moins de 17% de la profondeur de champ, ce qui est acceptable.

Le procédé qui vient d'être décrit présente l'avantage de réaliser successivement les traitements de photolithographie et de gravure critiques (étapes S7, S8, S9 et S11), c'est-à-dire déterminants sur les performances électriques des composants électroniques réalisés. Dans l'art antérieur, le traitement de photolithographie et de gravure des tranchées était effectué entre le traitement de photolithographie et la gravure finale des structures électriquement critiques. Cet avantage offre la possibilité de réaliser les traitements de photolithographie et de gravure critiques sans avoir à changer de machine de gravure. Cela permet aussi de mettre en oeuvre de manière optimale des boucles de régulation de type "Feed Forward". Ce procédé présente également l'avantage de n'avoir à effectuer que deux contrôles dimensionnels critiques au lieu de trois comme dans le procédé de l'art antérieur. En effet, le contrôle dimensionnel effectué à l'étape S4 ne concerne pas des motifs critiques en ce qui concerne la formation des composants électroniques.

En pratique, pour atteindre une largeur de ligne D2 de l'ordre de 30 nm, les résines photosensibles employées présentent des propriétés planarisantes et anti-réflectives. Les propriétés planarisantes et anti-réflectives des résines photosensibles sont généralement insuffisantes pour atteindre des dimensions critiques inférieures à 100 nm. La propriété anti-réflective est caractérisée par un coefficient de réflexion du faisceau de particules émis par la machine de photolithographie inférieur à 1%, ou 0,5%. Cette propriété peut être obtenue à l'aide d'un revêtement anti-réflectif BARC ("Bottom Anti Reflective Coating") formé sous la couche de résine PR' et éventuellement sous la couche PR. Le revêtement BARC peut être réalisé par couchage d'une résine antiréflective, ou par dépôt (CVD - Chemical Vapor Deposition, PECVD - Plasma-Enhanced Chemical Vapor Deposition, ...) d'une couche organique (par exemple en carbone amorphe) et/ou d'une couche diélectrique (par exemple en oxyde de silicium SiO₂, nitrure de silicium Si₃N₄, ...).

Une autre solution consiste à associer les couches PR et PR' à une couche de masque dur et une couche en un matériau planarisant et anti-réflectif, non nécessairement photosensible. La figure 6 représente une structure multicouche qui peut être formée aux étapes S1 et S7. Sur la figure 6, la couche de masque dur HM déposée sur la couche cible TL, est recouverte d'une couche AL en un matériau anti-réflectif et planarisant, par exemple à base de carbone. La couche AL est recouverte d'une couche de masque dur HM1, sur laquelle est déposée la couche de résine photosensible PR, PR'. Les couches HM et HM1 peuvent être formées en oxyde de silicium, en nitrure de silicium, ou en nitrure de titane TiN. La couche AL est réalisée un matériau capable de couvrir la couche HM en pénétrant dans les tranchées formées à l'étape S5 sans emprisonner de bulles de gaz, et présenter une face supérieure plane à l'issue de son dépôt sur la couche HM. La couche AL présente également des propriétés antiréflectives c'est-à-dire un coefficient de réflexion du faisceau de particules émis par la machine de photolithographie inférieur à 1%. La couche AL peut comprendre un film organique (par exemple en carbone) déposé par centrifugation ou par CVD ou PECVD. Les couches AL, HM1 et PR sont reformées à chaque transfert de motifs de masque à la couche HM. Les différentes couches déposées sur la couche cible TL peuvent être formées par PVD (Physical Vapor Deposition) ou CVD, ou encore par centrifugation. Les traitements de développement des couches photosensibles PR, PR' après exposition, et les traitements de gravure des couches de masque dur HM, HM1, de la couche AL et de la couche cible TL, sont adaptés aux dimensions à obtenir et aux matériaux à graver, et peuvent mettre en oeuvre des techniques connues.

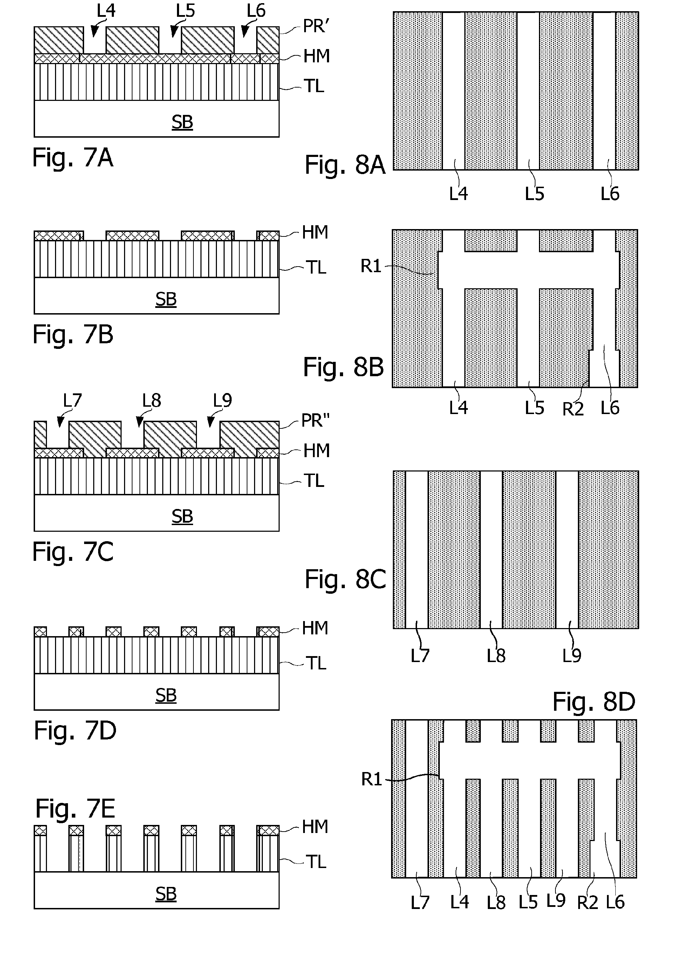

Pour augmenter la densité des structures transférées dans la couche HM, les étapes S7 à S10 peuvent être répétées avec des masques formant des motifs complémentaires tels que la combinaison des masques permet de former des structures à haute densité. Ces structures à haute densité sont généralement coupées après leur formation dans la couche de masque dur et avant leur transfert final dans la couche à graver. Selon un mode de réalisation, les étapes de formation de zones à supprimer (tranchées) dans la couche de masque dur sont réalisées avant les étapes multiples de formation des structures à haute densité (lignes). Les figures 7A à 7E illustrent différentes étapes d'un traitement de photolithographie permettant de transférer successivement les motifs de trois masques. Comme précédemment, les étapes S1 à S6, correspondant aux figures 4A à 4C, sont réalisées pour transférer les motifs R1, R2 représentés sur la figure 5A à la couche de masque dur HM. Ensuite une nouvelle couche en un matériau photosensible PR' est déposée sur la couche HM. Des motifs tels que ceux représentés sur les figures 7A, 8A sont transférés à la couche PR'. Sur les figures 7A, 8A, les motifs comprennent trois lignes parallèles L4, L5, L6 dont la largeur peut être égale à la dimension critique du traitement de photolithographie. Sur la figure 7A, les lignes L5, L6, L7 forment des tranchées dans la couche PR'. Les motifs formés dans la couche PR' sont ensuite transférés dans la couche HM, comme illustré par la figure 7B. D'après la figure 8B, la couche HM se trouve creusée à la fois par les tranchées correspondant aux lignes L4, L5, L6 et les tranchées correspondant aux zones rectangulaires R1, R2 (figure 5A).

Sur la figure 7C, une nouvelle couche en un matériau photosensible PR" est ensuite déposé sur la couche HM, et de nouveaux motifs sont transférés dans la couche PR". D'après la figure 8C, les nouveaux motifs transférés comprennent des lignes parallèles L7, L8, L9 qui sont transférées dans la couche PR" en formant des tranchées entre les lignes L4, L5, L6. La couche PR" permet de transférer les motifs L7, L8, L9 à la couche HM comme représenté sur les figures 7D et 8D. Ainsi, sur la figure 8D, la couche HM rassemble les tranchées R1, R2, et les lignes L4 à L9. La couche cible TL est ensuite gravée aux motifs formés dans la couche HM. Les lignes entre les tranchées formées par les lignes L4 à L9 forment par exemple des grilles de transistors CMOS.

Le procédé qui vient d'être décrit (mettant en oeuvre trois projections de masque) permet ainsi d'atteindre un espacement de lignes deux fois plus petit que celui obtenu par le procédé utilisant précédent, mettant en oeuvre deux projections de masque (figures 4A à 4F et figures 5A à 5C). Bien entendu, si les dimensions des motifs le permettent, il peut aisément être envisagé de procéder à d'autres gravures de motifs pour augmenter la densité des motifs transférés à la couche cible. Dans ces définitions multiples de structures, la définition des zones à supprimer (cut) dans la couche de masque dur est effectuée avant de définir les structures à dimension critique.

Il apparaîtra clairement à l'homme de l'art que la présente invention est susceptible de diverses variantes de réalisation et diverses applications. En particulier, l'invention n'est pas limitée à la gravure d'une couche en polysilicium pour former des grilles de transistors, mais peut s'appliquer à la gravure de couches de masques durs pour réaliser des dopages de zones du substrat ou d'une couche en un matériau semi-conducteur, ou des gravures de diverses couches formées sur une plaquette en un matériau semi-conducteur.

Les diverses couches présentées sur la figure 6 peuvent être déposées uniquement pour réaliser la deuxième gravure de la couche de masque dur HM et d'éventuelles gravures suivantes.

La présente invention n'est pas non plus limitée à des motifs de forme rectangulaire pour les motifs de ligne et de coupe. D'autres formes de motif polygonales plus complexes peuvent bien entendu être transférées à la couche de masque dur et à la couche cible.

## Revendications

1. Procédé de gravure d'une couche cible, comprenant des étapes consistant à :
déposer une couche de masque dur (HM) sur une couche cible (TL) et sur la couche de masque dur, une première couche en un matériau photosensible (PR),
exposer la première couche photosensible à un faisceau de particules au travers d'un premier masque (MSK1) pour transférer des premiers motifs,
former les premiers motifs dans la couche photosensible,
transférer les premiers motifs dans la couche de masque dur par gravure de cette couche au travers de la première couche photosensible,
déposer sur la couche de masque dur gravée une seconde couche en un matériau photosensible (PR'),
exposer la seconde couche photosensible à un faisceau de particules au travers d'un second masque (MSK2) pour transférer des seconds motifs,
former les seconds motifs dans la seconde couche photosensible,
transférer les seconds motifs dans la couche de masque dur par gravure de cette couche au travers de la seconde couche photosensible, et
transférer les premiers et seconds motifs dans la couche cible par gravure de cette couche au travers de la couche de masque dur,
dans lequel les seconds motifs forment des lignes (L1, L2, L3) dans la couche de masque dur, et les premiers motifs (R1, R2) forment des tranchées coupant les lignes dans la couche de masque dur.

2. Procédé selon la revendication 1, dans lequel entre les étapes de seconde gravure de la couche de masque dur (HM) et de gravure de la couche cible (TL), il comprend des étapes consistant à :
déposer sur la couche de masque dur gravée (HM) une troisième couche en un matériau photosensible (PR"),
exposer la troisième couche photosensible à un faisceau de particules au travers d'un troisième masque pour transférer des troisièmes motifs (L4, L5, L6),
former les troisièmes motifs dans la troisième couche photosensible,
et
transférer les troisièmes motifs dans la couche de masque dur par gravure de cette couche au travers de la troisième couche photosensible,
la couche cible étant gravée en recevant les premiers (R1, R2), seconds (L1, L2, L3) et troisièmes motifs (L4, L5, L6) formés dans la couche de masque dur, les troisièmes motifs formant des lignes coupées par les premiers motifs.

3. Procédé selon l'une des revendications 1 et 2, dans lequel l'une ou chacune des couches photosensibles (PR, PR', PR") est déposée directement sur la couche de masque dur (HM), préalablement gravée ou non, la couche photosensible présentant un coefficient de réflexion du faisceau de particules inférieur à 1%, et une face supérieure plane, et couvre la couche de masque dur sans emprisonner de bulles de gaz.

4. Procédé selon la revendication 3, dans lequel la surface supérieure de l'une ou de chacune des couches photosensibles (PR, PR', PR") présente une variation de hauteur inférieure à 20%, et de préférence, inférieure à 15%.

5. Procédé selon l'une des revendications 1 et 2, dans lequel une couche supplémentaire (AL) est déposée directement sur la couche de masque dur (HM), préalablement gravée ou non, l'une ou chacune des couches photosensibles (PR, PR', PR") étant déposée sur la couche supplémentaire, le procédé comprenant une étape de gravure de la couche supplémentaire pour transférer les motifs formés dans la couche photosensible à la couche supplémentaire.

6. Procédé selon la revendication 5, dans lequel la couche supplémentaire (AL) présente un coefficient de réflexion du faisceau de particules inférieur à 1 %, et une face supérieure plane, et couvre la couche de masque dur sans emprisonner de bulles de gaz.

7. Procédé selon l'une des revendications 5 et 6, dans lequel la surface supérieure de l'une ou de chacune des couches photosensibles (PR, PR', PR") présente une variation de hauteur inférieure à 20%, et de préférence, inférieure à 15%.

8. Procédé selon l'une des revendications 6 et 7, dans lequel l'une ou chacune des couches photosensibles (PR, PR', PR") est déposée sur une seconde couche de masque dur (HM1), la seconde couche de masque dur étant déposée sur la couche supplémentaire (AL), le procédé comprenant une étape de gravure de la seconde couche de masque dur pour transférer les motifs formés dans la couche photosensible à la couche de masque dur.

9. Procédé selon l'une des revendications 1 à 8, dans lequel la couche cible (TL) est une couche prévue pour former des grilles de transistors CMOS.
